# EUROPEAN PATENT SPECIFICATION

(11) **EP 2 502 705 B1**
(45) Date of publication and mention of the grant of the patent: **14.05.2014**
(21) Application number: 12004630.5
(22) Date of filing: 29.10.2008
(51) Int. Cl.: B24B 37/32

(54) **Polishing apparatus**
Poliervorrichtung
Appareil de polissage

(30) Priority: 29.10.2007 JP 2007280389; 07.05.2008 JP 2008121138
(43) Date of publication of application: 26.09.2012
(62) Divisional of application: 08018885.7
(73) Proprietor: EBARA CORPORATION, Ohta-ku Tokyo (JP)
(72) Inventor: Nabeya, Osamu, Tokyo (JP); Togawa, Tetsuji, Tokyo (JP); Yasuda, Hozumi, Tokyo (JP); Saito, Koji, Tokyo (JP); Fukushima, Makoto, Tokyo (JP)
(74) Representative: Klang, Alexander H.

(56) References cited:
- EP-A2- 1 034 888
- EP-A2- 1 839 812
- WO-A1-2006/062232
- JP-A- 2000 271 860
- US-A1- 2004 137 832
- US-A1- 2006 160 479

## Description

### BACKGROUND OF THE INVENTION

### Field of the Invention

The present invention relates to a polishing apparatus, and more particularly to a polishing apparatus for polishing an object to be polished (substrate) such as a semiconductor wafer to a flat mirror finish.

### Description of the Related Art

In recent years, high integration and high density in semiconductor device demands smaller and smaller wiring patterns or interconnections and also more and more interconnection layers. Multilayer interconnections in smaller circuits result in greater steps which reflect surface irregularities on lower interconnection layers. An increase in the number of interconnection layers makes film coating performance (step coverage) poor over stepped configurations of thin films. Therefore, better multilayer interconnections need to have the improved step coverage and proper surface planarization. Further, since the depth of focus of a photolithographic optical system is smaller with miniaturization of a photolithographic process, a surface of the semiconductor device needs to be planarized such that irregular steps on the surface of the semiconductor device will fall within the depth of focus.

Thus, in amanufacturingprocess of a semiconductor device, it increasingly becomes important to planarize a surface of the semiconductor device. One of the most important planarizing technologies is chemical mechanical polishing (CMP). Thus, there has been employed a chemical mechanical polishing apparatus for planarizing a surface of a semiconductor wafer. In the chemical mechanical polishing apparatus, while a polishing liquid containing abrasive particles such as silica (SiO₂ therein is supplied onto a polishing surface such as a polishing pad, a substrate such as a semiconductor wafer is brought into sliding contact with the polishing surface, so that the substrate is polished.

This type of polishing apparatus includes a polishing table having a polishing surface formed by a polishing pad, and a substrate holding device, which is referred to as a top ring or a polishing head, for holding a substrate such as a semiconductor wafer. When a semiconductor wafer is polished with such a polishing apparatus, the semiconductor wafer is held and pressed against the polishing surface under a predetermined pressure by the substrate holding device. At this time, the polishing table and the substrate holding device are moved relative to each other to bring the semiconductor wafer into sliding contact with the polishing surface, so that the surface of the semiconductor wafer is polished to a flat mirror finish.

In such polishing apparatus, if the relative pressing force applied between the semiconductor wafer, being polished, and the polishing surface of the polishing pad is not uniform over the entire surface of the semiconductor wafer, then the surface of the semiconductor wafer is polished insufficiently or excessively in different regions thereof depending on the pressing force applied thereto. It has been customary to uniformize the pressing force applied to the semiconductor wafer by providing a pressure chamber formed by an elastic membrane at the lower portion of the substrate holding device and supplying the pressure chamber with a fluid such as air to press the semiconductor wafer under a fluid pressure through the elastic membrane, as seen in Japanese laid-open patent publication No.2006-255851.

In this case, the polishingpad is so elastic that pressing forces applied to a peripheral portion of the semiconductor wafer being polished become non-uniform, and hence only the peripheral portion of the semiconductor wafer may excessively be polished, which is referred to as "edge rounding" . In order to prevent such edge rounding, the retainer ring for holding the peripheral edge of the semiconductor wafer is vertically movable with respect to the top ring body (or carrier head body) to press an annular portion of the polishing surface of the polishing pad that corresponds to the peripheral portion of the semiconductor wafer by the retainer ring.

In the conventional polishing apparatus, a lateral force (horizontal force) is applied to the retainer ring by a frictional force between the semiconductor wafer and the polishing surface of the polishing pad during polishing, and the lateral force (horizontal force) is received by a retainer ring guide provided at an outer circumferential side of the retainer ring. Therefore, when the retainer ring is vertically moved to follow undulation of the polishing surface of the polishing pad, a large frictional force is generated at sliding contact surfaces of an outer circumferential surface of the retainer ring and an inner circumferential surface of the retainer ring guide. Thus, the following capability of the retainer ring becomes insufficient, and a desired surface pressure of the retainer ring cannot be applied to the polishing surface of the polishing pad.

Further, in order to transmit a rotative force from the top ring (or carrier head) to the retainer ring, a rotary drive unit such as driving pins is provided between the retainer ring and the retainer ring guide. When the retainer ring is vertically moved, a large frictional force is generated at the rotary drive unit. Thus, the following capability of the retainer ring becomes insufficient, and a desired surface pressure of the retainer ring cannot be applied to the polishing surface of the polishing pad.

Furthermore, reference is made to EP 1839812 A2, showing a polishing apparatus in accordance with the preamble of claim 1.

### SUMMARY OF THE INVENTION

The present invention has been made in view of the above drawbacks. It is therefore an object of the present invention to provide a polishing apparatus which can improve the following capability of a retainer ring against a polishing surface, the retainer ring for holding a peripheral edge of a substrate being provided at a peripheral portion of a top ring for holding the substrate, and can apply a desired surface pressure of the retainer ring to the polishing surface.

In order to achieve the above object, according to the present invention, there is provided an apparatus for polishing a substrate as set forth in claim 1. Further embodiments of the invention may be found in the dependent claims. In particular, there is provided an apparatus for polishing a substrate, comprising: a polishing table having a polishing surface; a top ring body configured to hold and press a substrate against the polishing surface; a retainer ring provided at an outer peripheral portion of the top ring body and configured to press the polishing surface; and a retainer ring guide fixed to the top ring body and configured to be brought into sliding contact with a ring member of then retainer ring to guide a movement of the ring member. A low friction material member, having a coefficient of friction of 0.35 or less, is provided on an outer circumference of said ring member of said retainer ring to bring said low friction material member into sliding contact with said retainer ring guide, wherein said low friction material member comprises a belt-like or block-like member having both ends, wherein a plurality of said belt-like or block-like members are provided on an outer circumference of said ring member in such a manner that a clearance is formed between the adjacent belt-like or block-like members.

According to the present invention, because the low friction material member, is fitted onto an outer circumference of the ring member of the retainer ring, when the retainer ring is vertically moved to follow undulation of the polishing surface of the polishing table, a frictional forces of the sliding contact surfaces (sliding surfaces) of the ring member of the retainer ring and the retainer ring guide can be remarkably reduced to enhance the following capability of the retainer ring with respect to the polishing surface, and a desired surface pressure of the retainer ring can be applied to the polishing surface.

It is desirable that the low friction material has a coefficient of friction of 0.25 or less. The coefficient of friction is dimensionless value under conditions of no lubricating oil. Further, it is desirable that the low friction material comprises a sliding material having high wear resistance.

In a preferred aspect of the present invention, mirror processing is applied to the other sliding contact surfaces of the retainer ring guide.

According to the present invention, a frictional force of the ring member of the retainer ring and the retainer ring guide can be further reduced.

In a preferred aspect of the present invention, the low friction material member comprises a resin material comprising polytetrafluoroethylene (PTFE) or PEEK·PPS.

Besides the above resin material, the low friction material may comprise a resin material comprising PET, polyethylene, polyamide, polyacetal, polyimide, or polyamide-imide.

In a preferred aspect of the present invention, the low friction material member comprises a flexible member; and the low friction material member is mounted on the ring member to become a circular shape corresponding to an outer circumference of the ring member.

In a preferred aspect of the present invention, the polishing apparatus further comprises a retaining device provided at a location where the low friction material member is fitted onto the ring member and configured to prevent the low friction material member from dropping out of the ring member.

According to the present invention, a retaining device prevents the low friction material member from dropping out of the ring member of the retainer ring. This retaining device may be composed of a projection formed in one of the low friction material member and the ring member and a recess formed in the other of the low friction material member and the ring member.

According to the present invention, when the low friction material member is fittedonto the ring member, a small clearance is formed between the two adjacent low frictionmaterial members. This clearance is arranged to prevent the ends of the two adjacent low friction material members from coming into contact with each other, even if the low friction material members are' thermally expanded due to temperature rise of the retainer ring as polishing process progresses. The clearance is preferably in the range of about 0.1mm to about 1mm in view of thermal expansion coefficient of the low friction material member.

In a preferred aspect of the present invention, the polishing apparatus further comprises a rotation-prevention device configured to prevent the low friction material member from being rotated with respect to the ring member.

According to the present invention, the low friction material member is prevented from being rotated in a circumferential direction of the ring member during polishing. This rotation-prevention device may be composed of a projection formed in one of the low friction material member and the ring member and a recess formed in the other of the low friction material member and the ring member.

According to the present invention, when the retainer ring is vertically moved to follow undulation of the polishing surface of the polishing table, a frictional force of the sliding contact surfaces of the retainer ring and the retainer ring guide can be remarkably reduced to enhance the following capability of the retainer ring with respect to the polishing surface, and a desired surface pressure of the retainer ring can be applied to the polishing surface.

Further, according to the present invention, when the retainer ring is vertically moved to follow undulation of the polishing surface of the polishing table, the vertically moved retainer ring can be supported by the fluid film with no-sliding (noncontact). Thus, the following capability of the retainer ring with respect to the polishing surface can be enhanced, and a desired surface pressure of the retainer ring can be applied to the polishing surface.

The above and other objects, features, and advantages of the present invention will become apparent from the following description when taken in conjunction with the accompanying drawings which illustrate preferred embodiments of the present invention by way of example.

### BRIEF DESCRIPTION OF THE DRAWINGS

FIG. 1 is a schematic view showing an entire structure of a polishing apparatus;
FIG. 2 is a cross-sectional view showing a top ring shown in FIG. 1;
FIG. 3 is a cross-sectional view showing the top ring shown in FIG. 1;
FIG. 4 is a cross-sectional view showing the top ring shown in FIG. 1;
FIG. 5 is a cross-sectional view showing the top ring shown in FIG. 1;
FIG. 6 is a cross-sectional view showing the top ring shown in FIG. 1;
FIG. 7 is an enlarged view of A part of a retainer ring shown in FIG. 4;
FIG. 8 is a view showing the configuration of a retainer ring guide and a ring member not according to the present invention;
FIG. 9 is an enlarged view of B part of the retainer ring shown in FIG. 4;
· FIG. 10 is a view as viewed from line X-X of FIG. 9;
· FIG. 11 is a schematic cross-sectional view showing a top ring not according to the present invention;
FIG. 12 is an enlarged view of a main part of FIG. 11;
FIG. 13 is a cross-sectional view showing a retainer ring are disclose according to an embodiment of the present invention; and is a view corresponding to FIG. 8; and
FIG. 14 is an enlarged view of a main part of FIG. 13 showing a fitting portion of a groove of a lower ring member and a low friction material member.

### DETAILED DESCRIPTION OF THE PREFERRED EMBODIMENTS

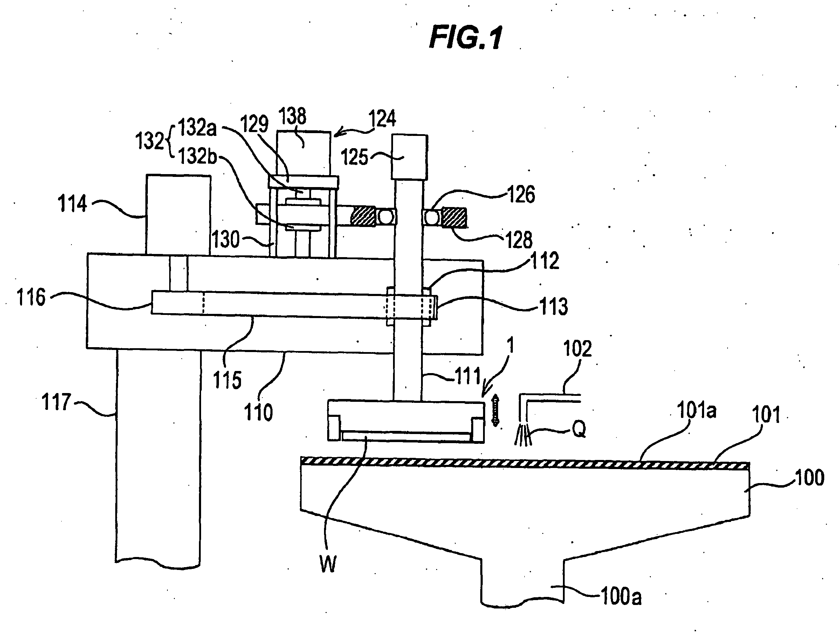

A polishing apparatus will be described below with reference to FIGS. 1 through 14. Like or corresponding parts are denoted by like or corresponding reference numerals throughout drawings and will not be described below repetitively.

FIG. 1 is a schematic view showing an entire structure of the polishing apparatus. As shown in FIG. 1, the polishing apparatus comprise a polishing table 100, and a top ring 1 for holding a substrate such as a semiconductor wafer as an object to be polished and pressing the substrate against a polishing surface on the polishing table 100.

The polishing table 100 is coupled via a table shaft 100a to a motor (not shown) disposed below the polishing table 100. Thus, the polishing table 100 is rotatable about the table shaft 100a. A polishing pad 101 is attached to an upper surface of the polishing table 100. An upper surface 101a of the polishing pad 101 constitutes a polishing surface to polish a semiconductor wafer W. A polishing liquid supply nozzle 102 is provided above the polishing table 100 to supply a polishing liquid Q onto the polishing pad 101 on the polishing table 100.

The top ring 1 is connected to a lower end of a top ring shaft 111, which is vertically movable with respect to a top ring head 110 by a vertically moving mechanism 124. When the vertically moving mechanism 124 moves the top ring shaft 111 vertically, the top ring 1 is lifted and lowered as a whole for positioning with respect to the top ring head 110. A rotary joint 125 is mounted on the upper end of the top ring shaft 111.

The vertically moving mechanism 124 for vertically moving the top ring shaft 111 and the top ring 1 comprises a bridge 128 on which the top ring shaft 111 is rotatably supported by a bearing 126, a ball screw 132 mounted on the bridge 128, a support base 129 supported by support posts 130, and an AC servomotor 138 mounted on the support base 129. The support base 129, which supports the AC servomotor 138 thereon, is fixedly mounted on the top ring head 110 by the support posts 130.

The ball screw 132 comprises a screw shaft 132a coupled to the AC servomotor 138 and a nut 132b threaded over the screw shaft 132a. The top ring shaft 111 is vertically movable in unison with the bridge 128 by the vert'ically moving mechanism 124. When the AC servomotor 138 is energized, the bridge 128 moves vertically via the ball screw 132, and the top ring shaft 111 ahd the top ring 1 move vertically.

The top ring shaft 111 is connected to a rotary sleeve 112 by a key (not shown). The rotary sleeve 112 has a timing pulley 113 fixedly disposed therearound. A top ring motor 114 having a drive shaft is fixed to the top ring head 110. The timing pulley 113 is operatively coupled to a timing pulley 116 mounted on the drive shaft of the top ring motor 114 by a timing belt 115. When the top ring motor 114 is energized, the timing pulley 116, the timingbelt 115, and the timingpulley 113 are rotated to rotate the rotary sleeve 112 and the top ring shaft 111 in unison with each other, thus rotating the top ring 1. The top ring head 110 is supported on a top ring head shaft 117 fixedly supported on a frame (not shown).

In the polishing apparatus constructed as shown in FIG. 1, the top ring 1 is configured to hold the substrate such as a semiconductor wafer W on its lower surface. The top ring head 110 is pivotable (swingable) about the top ring head shaft 117. Thus, the top ring 1, which holds the semiconductor wafer W on its lower surface, is moved between a position at which the top ring 1 receives the semiconductor wafer W and a position above the polishing table 100 by pivotal movement of the top ring head 110. The top ring 1 is lowered to press the semiconductor wafer W against a surface (polishing surface) 101a of the polishing pad 101. At this time, while the top ring 1 and the polishing table 100 are respectively rotated, a polishing liquid is supplied onto the polishing pad 101 by the polishing liquid supply nozzle 102 provided above the polishing table 100. The semiconductor wafer W is brought into sliding contact with the polishing surface 101a of the polishing pad 101. Thus, a surface of the semiconductor wafer W is polished.

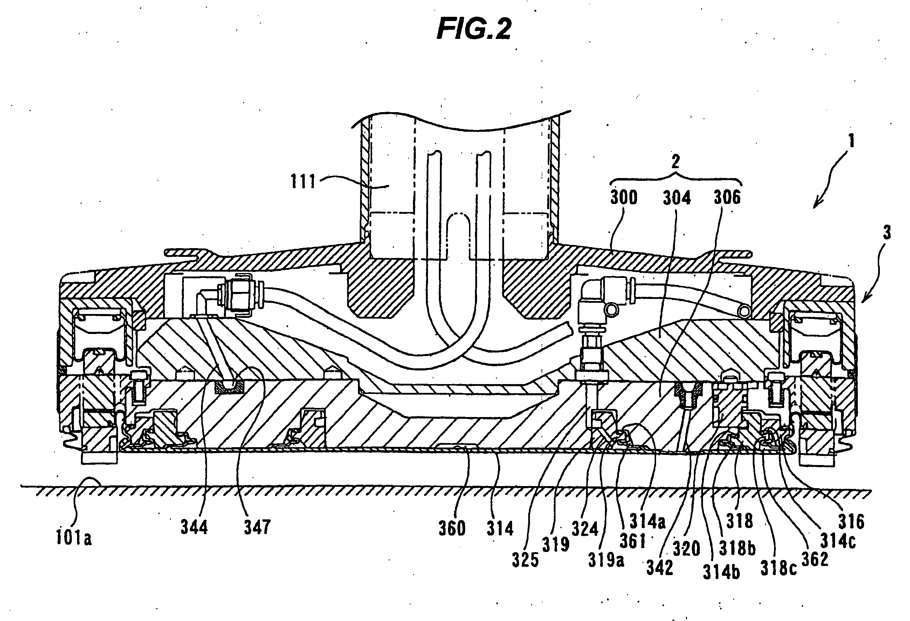

FIGS. 2 through 6 are cross-sectional views showing an example of the top ring 1 along a plurality of radial directions of the top ring 1.

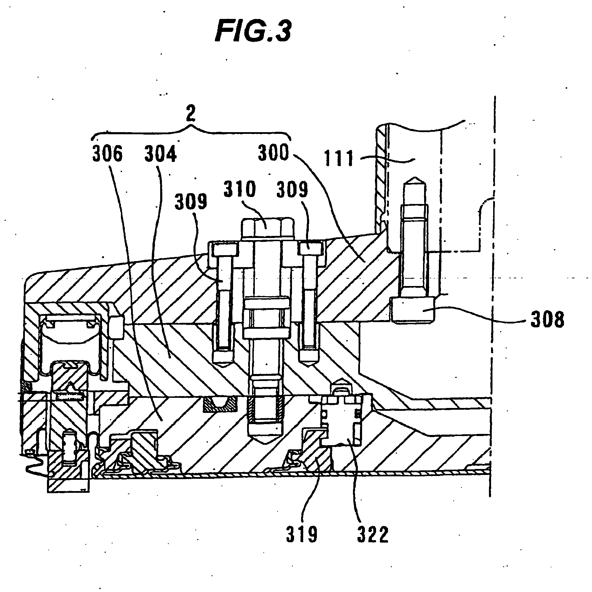

As shown in FIGS. 2 through 6, the top ring 1 basically comprises a top ring body 2 for pressing a semiconductor wafer W against the polishing surface 101a, and a retainer ring 3 for directly pressing the polishing surface 101a. The top ring body 2 includes an upper member 300 in the form of a circular plate, an intermediate member 304 attached to a lower surface of the upper member 300, and a lower member 306 attached to a lower surface of the intermediate member 304. The retainer ring 3 is attached to a peripheral portion of the upper member 300. As shown -in FIG. 3, the upper member 300 is connected to the top ring shaft 111 by bolts 308. Further, the intermediate member 304 is fixed to the upper member 300 by bolts 309, and the lower member 306 is fixed to the upper member 300 by bolts 310. The top ring body 2 comprising the upper member 300, the intermediate member 304, and the lower member 306 is made of resin such as engineering plastics (e.g., PEEK).

As shown in FIG. 2, the top ring 1 has an elastic membrane 314 attached to a lower surface of the lower member 306. The elastic membrane 314 is brought into contact with a rear face of a semiconductor wafer held by the top ring 1. The elastic membrane 314 is held on the lower surface of the lower member 306 by an annular edge holder 316 disposed radially outward and annular ripple holders 318 and 319 disposed radially inward of the edge holder 316. The elastic membrane 314 is made of a highly strong and durable rubber material such as ethylene propylene rubber (EPDM), polyurethane rubber, silicone rubber, or the like.

The edge holder 316 is held by the ripple holder 318, and the ripple holder 318 is held on the lower surface of the lower member 306 by a plurality of stoppers 320. As shown in FIG. 3, the ripple holder 319 is held on the lower surface of the lower member 306 by a plurality of stoppers 322. The stoppers 320 and the stoppers 322 are arranged along a circumferential direction of the top ring 1 at equal intervals.

As shown in FIG. 2, a central chamber 360 is formed at a central portion of the elastic membrane 314. The ripple holder 319 has a passage 324 communicating with the central chamber 360. The lower member 306 has a passage 325 communicating with the passage 324. The passage 324 of the ripple holder 319 and the passage 325 of the lower member 306 are connected to a fluid supply source (not shown). Thus, a pressurized fluid is supplied through the passages 325 and 324 to the central chamber 360 formed by the elastic membrane 314.

The ripple holder 318 has claws 318b and 318c for pressing a ripple 314b and an edge 314c of the elastic membrane 314 against the lower surface of the lower member 306. The ripple holder 319 has a claw 319a for pressing a ripple 314a of the elastic membrane 314 against the lower surface of the lower member 306.

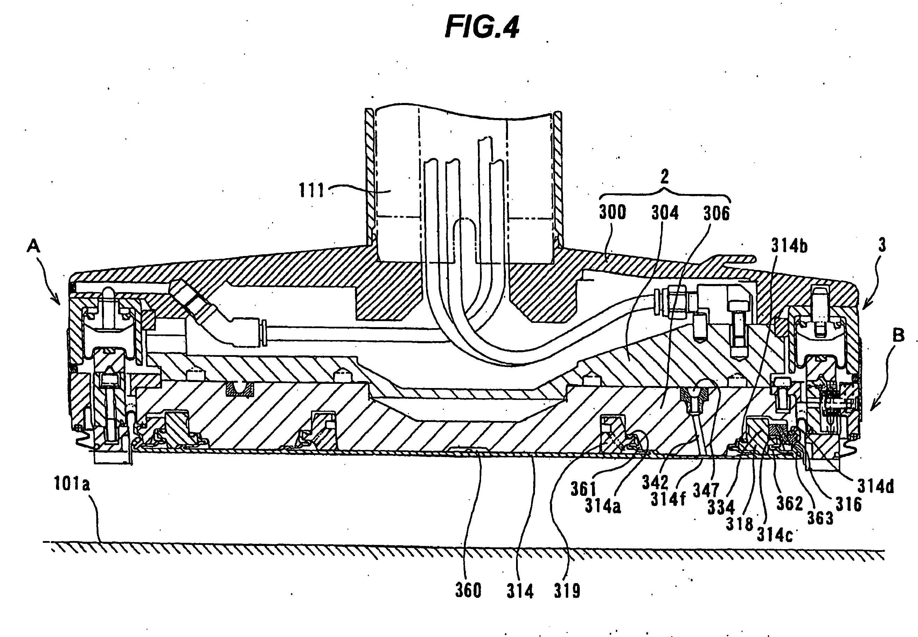

As shown in FIG. 4, an annular ripple chamber 361 is formed between the ripple 314a and the ripple 314b of the elastic membrane 314. A gap 314f is formed between the ripple holder 318 and the ripple holder 319 of the elastic membrane 314. The lower member 306 has a passage 342 communicating with the gap 314f. Further, as shown in FIG. 2, the intermediate member 304 has a passage 344 communicating with the passage 342 of the lower member 306. An annular groove 347 is formed at a connecting portion between the passage 342 of the lower member 306 and the passage 344 of the intermediate member 304. The passage 342 of the lower member 306 is connected via the annular groove 347 and the passage 344 of the intermediate member 304 to a fluid supply source (not shown). Thus, a pressurized fluid is supplied through these passages to the ripple chamber 361. Further, the passage 342 is selectively connected to a vacuum pump (not shown). When the vacuum pump is operated, a semiconductor wafer is attracted to the lower surface of the elastic membrane 314 by suction, thereby chucking the semiconductor wafer.

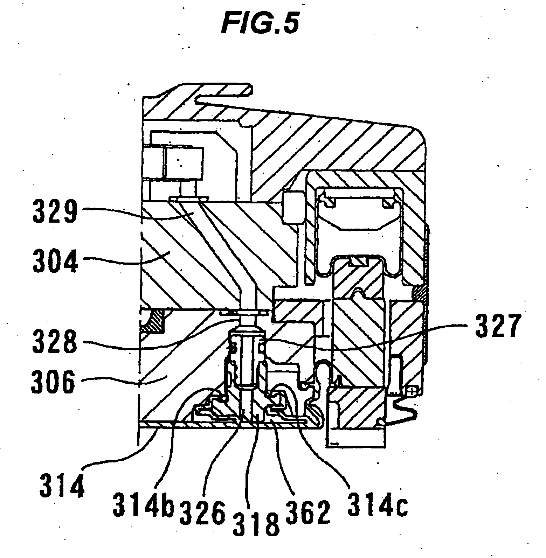

As shown in FIG. 5, the ripple holder 318 has a passage 326 communicating with an annular outer chamber .362 formed by the ripple 314b and the edge 314c of the elastic membrane 314. Further, the lower member 306 has a passage 328 communicating with the passage 326 of the ripple holder 318 via a connector 327. The intermediate member 304 has a passage 329 communicating with the passage 328 of the lower member 306. The passage 326 of the ripple holder 318 is connected via the passage 328 of the lower member 306 and the passage 329 of the intermediate member 304 to a fluid supply source (not shown). Thus, a pressurized fluid is supplied through these passages to the outer chamber 362 formed by the elastic membrane 314.

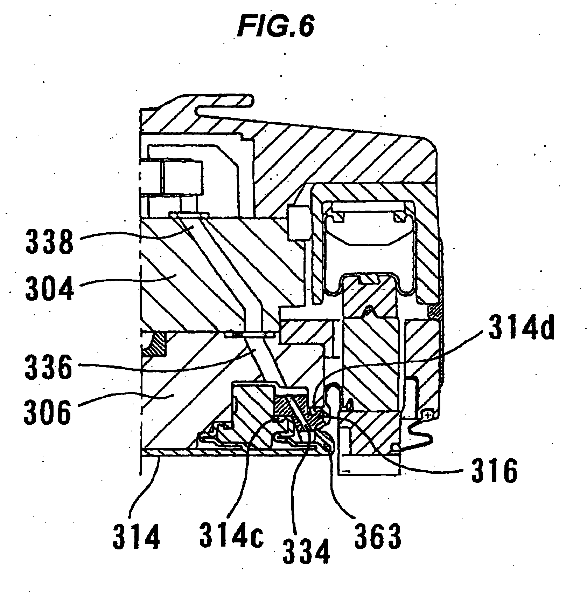

As shown in FIG. 6, the edge holder 316 has a claw for holding an edge 314d of the elastic membrane 314 on the lower surface of the lower member 306. The edge holder 316 has a passage 334 communicating with an annular edge chamber 363 formed by the edges 314c and 314d of the elastic membrane 314. The lower member 306 has a passage 336 communicating with the passage 334 of the edge holder 316. The intermediate member 304 has a passage 338 communicating with the passage 336 of the lower member 306. The passage 334 of the edge holder 316 is connected via the passage 336 of the lower member 306 and the passage 338 of the intermediate member 304 to a fluid supply source (not shown). Thus, a pressurized fluid is supplied through these passages to the edge chamber 363 formed by the elastic membrane 314.

As described above, in the top ring 1 according to the present embodiment, pressing forces for pressing a semiconductor wafer against the polishing pad 101 can be adjuster at local areas of the semiconductor wafer by adjusting pressures of fluids to be supplied to the respective pressure chambers formed between the elastic membrane 314 and the lower member 306 (i.e., the central chamber 360, the ripple chamber 361, the outer chamber 362; and the edge chamber 363).

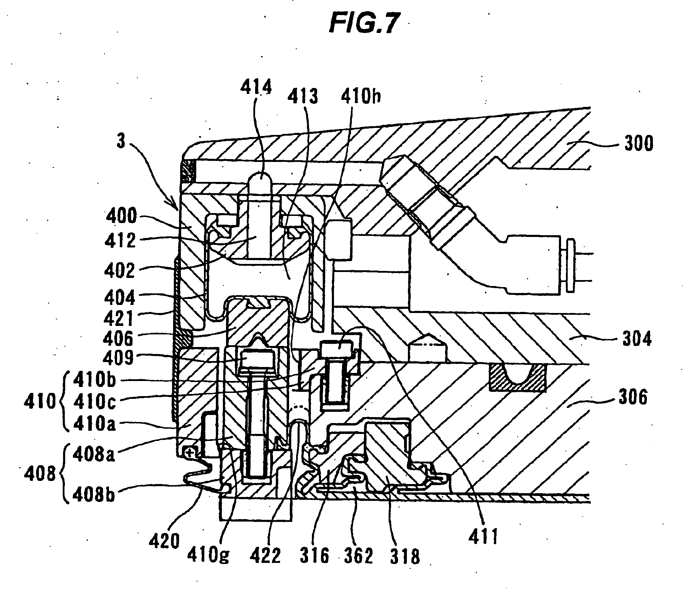

FIG. 7 is an enlarged view of the retainer ring 3 shown in FIG. 4. The retainer ring 3 serves to hold a peripheral edge of a semiconductor wafer. As shown in FIG. 7, the retainer ring 3 comprises a cylinder 400 having a cylindrical shape with a closed upper end, a holder 402 attached to an upper portion of the cylinder 400, an elastic membrane 404 held in the cylinder 400 by the holder 402, a piston 406 connected to a lower end of the elastic membrane 404, and a ring member 408 which is pressed downward by the piston 406.

The ring member 408 comprises an upper ring member 408a coupled to the piston 406, and a lower ring member 408b which is brought into contact with the polishing surface 101. The upper ring member 408a and the lower ring member 408b are coupled by a plurality of bolts 409. The upper ring member 408a is composed of a metal material such as SUS or a material such as ceramics, and the lower ring member 408b is made of a resin material such as PEEK or PPS.

As shown in FIG. 7, the holder 402 has a passage 412 communicating with a chamber 413 formed by the elastic membrane 404. The upper member 300 has a passage 414 communicating with the passage 412 of the holder 402. The passage 412 of the holder 402 is connected via the passage 414 of the upper member 300 to a fluid supply source (not shown). Thus, a pressurized fluid is supplied through the passages 414 and 412 to the chamber 413. Accordingly, by adjusting a pressure of the fluid to be supplied to the pressure chamber 413, the elastic membrane 404 can be expanded and contracted so as to vertically move the piston 406. Thus, the ring member 408 of the retainer ring 3 can be pressed against the polishing pad 101 under a desired pressure.

In the illustrated example, the elastic membrane 404 employs a rolling diaphragm formed by an elastic membrane having bent portions. When an inner pressure in a chamber defined by the rolling diaphragm is changed, the bent portions of the rolling diaphragm are rolled so as to widen the chamber. The diaphragm is not brought into sliding contact with outside components and is hardly expanded and contracted when the chamber is widened. Accordingly, friction due to sliding contact can extremelybe reduced, and a lifetime of the diaphragm can be prolonged. Further, pressing forces under which the retainer ring 3 presses the polishing pad 101 can accurately be adjusted.

With the above arrangement, only the ring member 408 of the retainer ring 3 can be lowered. Accordingly, a constant distance can be maintained between the lower member 306 and the polishing pad 101 even if the ring member 408 of the retainer ring 3 is worn out. Further, since the ring member 408, which is brought into contact with the polishing pad 101, and the cylinder 400 are connected by the deformable elastic membrane 404, no bending moment is produced by offset loads. Thus, surface pressures by the retainer ring 3 can be made uniform, and the retainer ring 3 becomes more lively to follow the polishing pad 101.

Further, as shown in FIG. 7, the retainer ring 3 has a ring-shaped retainer ring guide 410 for guiding vertical movement of the ring member 408. The ring-shaped retainer ring guide 410 comprises an outer peripheral portion 410a located at an outer circumferential side of the ring member 408 so as to surround an entire circumference of an upper portion of the ring member 408, an inner peripheral portion 410b located at an inner circumferential side of the ring member 408, and an intermediate portion 410c configured to connect the outer peripheral portion 410a and the inner peripheral portion 410b. The inner peripheral portion 410b of the retainer ring guide 410 is fixed to the lower member 306 of the top ring 1 by a plurality of bolts 411. The intermediate portion 410c configured to connect the outer peripheral portion 410a and the inner peripheral portion 410b has a plurality of openings 410h which are formed at equal intervals in a circumferential direction of the intermediate portion 410c.

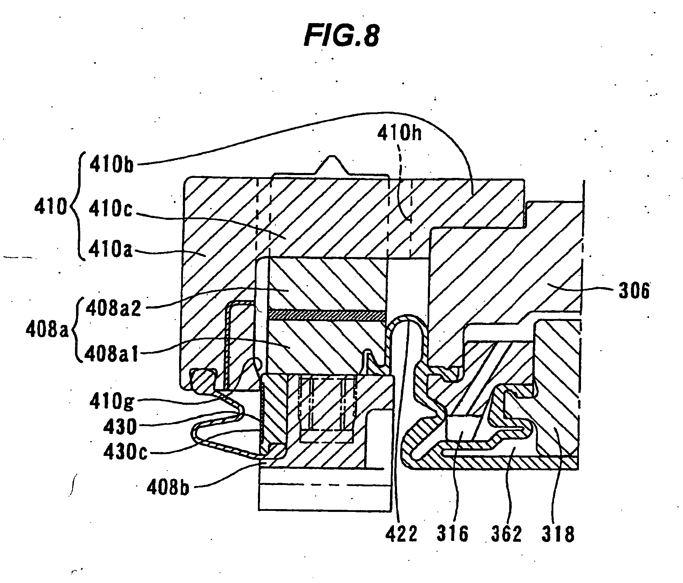

FIG. 8 shows the configuration of the retainer ring guide 410 and the ringmember 408. As shown in FIG. 8, the intermediate portion 410c is in the form of a ring as an entirely circumferentially continuous element, and has a plurality of circular arc openings 410h formed at equal intervals in a circumferential direction of the intermediate portion 410c. In FIG. 8, the circular arc opening 410h is shown by dotted lines.

On the other hand, the upper ring 408a of the ring member 408 comprises a lower ring portion 408a1 in the form of a ring as an entirely circumferentially continuous element, and a plurality of upper circular arc portions 408a2 projecting upwardly at equal intervals in a circumferential direction from the lower ring portion 408a1. Each of the upper circular arc portions 408a2 passes through the circular arc opening 410h and is coupled to the piston 4.06 (see FIG. 7).

As shown in FIG. 8, a thin metal ring 430 made of SUS or the like is fitted over the lower ring member 408b. A coating layer 430c made of a resin material such as PEEK·PPS filled with a filler such as polytetrafluoroethylene (PTFE) or PTFE is formed on an outer circumferential surface of the metal ring 430. The resin material such as PTFE or PEEK·PPS comprises a low friction material having a low coefficient of friction, and has excellent sliding characteristics. The low friction material is defined as a material having a low coefficient of friction of 0.35 or less. It is desirable that the low friction material has a coefficient of friction of 0.25 or less.

On the other hand, the inner circumferential surface of the outer peripheral portion 410a of the retainer ring guide 410 constitutes a guide surface 410g which is brought into sliding contact with the coating layer 430c. The guide surface 410g has an improved surface roughness by mirror processing. The mirror processing is defined as a processing including polishing, lapping, and buffing.

As shown in FIG. 8, since the metal ring 430 made of SUS or the like is fitted over the lower ring member 408b, the lower ring member 408b has an improved rigidity. Thus, even if a temperature of the ring member 408b increases due to the sliding contact between the ring member 408b and the polishing surface 101a, thermal deformation of the lower ring member 408b can be suppressed. Therefore, a clearance between outer circumferential surfaces of the metal ring 430 and the lower ring member 408b and an inner circumferential surface of the outer peripheral portion 410a of the retainer ring guide 410 can be narrowed, and abnormal noise or vibration generated at the time of collision between the retainer ring guide 410 and the ring member 408 caused by movement of the ring member 408 in the clearance can be suppressed. Further, since the coating layer 430c formed on the outer circumferential surface of the metal ring 430 is composed of a low friction material, and the guide surface 410g of the retainer ring guide 410 has an improved surface roughness by mirror processing, the sliding characteristics between the lower ring member 408b and the retainer ring guide 410 can be improved. Thus, the following capability of the ring member 408 with respect to the polishing surface can be remarkably enhanced, and a desired surface pressure of the retainer ring can be applied to the polishing surface.

In the example shown in FIG. 8, the metal ring 430 is coated with a low friction material such as PTFE or PEEK· PPS. However, a low friction material such as PTFE or PEEK· PPS may be directly provided on the outer circumferential surface of the lower ring member 408b by coating or adhesive. Further, a ring-shaped low friction material may be provided on the outer circumferential surface of the lower ring member 408b by double-faced tape. Further, the low friction material may be provided on the retainer ring guide 410, and mirror processing may be applied to the lower ring member 408b.

Further, both of the sliding contact surfaces of the retainer ring guide 410 and the lower ring member 408b may be subjected to mirror processing to improve sliding characteristics between the lower ring member 408b and the retainer ring guide 4110. In this manner, by applying mirror processing to both of the sliding contact surfaces of the retainer ring guide 410 and the lower ring member 408b, the following capability of the ring member 408 with respect to the polishing surface can be remarkably enhanced, and a desired surface pressure of the retainer ring can be applied to the polishing surface.

Further, the sliding contact surfaces of the lower ring member 408b of the retainer ring 3 and the retainer ring guide 410 may be coated with liquid or semisolid lubricant to improve the sliding characteristics between the lower ring member 408b of the retainer ring 3 and the retainer ring guide 410. In this manner, in the case where the sliding contact surfaces of the lower ring member 408b of the retainer ring 3 and the retainer ring guide 410 are coated with lubricant, when the retainer ring 3 is vertically moved to follow undulation of the polishing surface of the polishing table, a frictional force of the sliding contact surfaces of the lower ring member 408b of the retainer ring 3 and the retainer ring guide 410 can be remarkably reduced to enhance the following capability of the retainer ring 3 with respect to the polishing surface, and a desired surface pressure of the retainer ring 3 can be applied to the polishing surface.

Further, according to the present invention, since a connecting sheet 420 is provided between the outer circumferential surface of the lower ring member 408b and the retainer ring guide 410 at the location below the sliding contact surfaces (lubricant coated surfaces), the lubricant of the sliding contact surfaces can be prevented from falling onto the polishing surface. The lubricant is preferably in the form of liquid or semisolid such as silicon grease or lubricating oil.

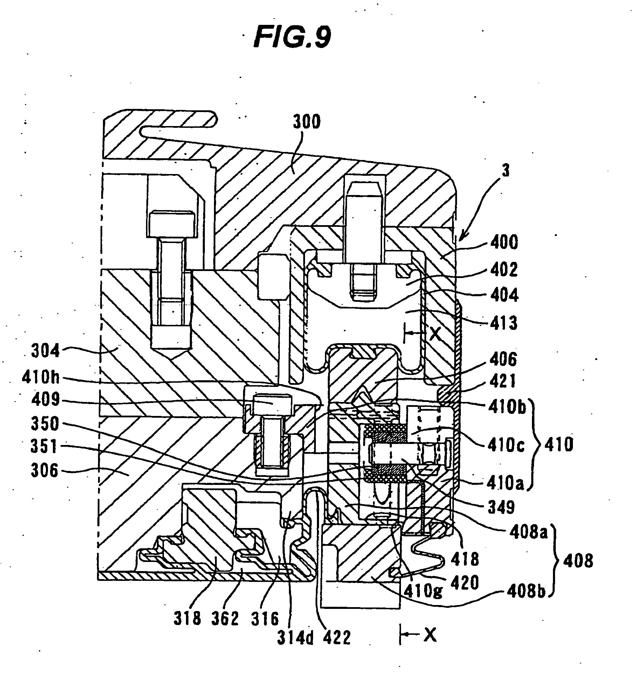

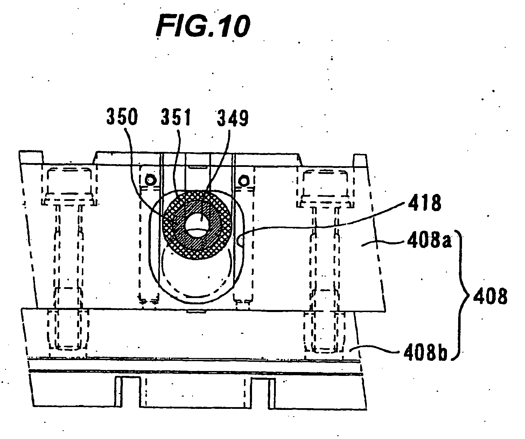

FIG. 9 is an enlarged view of B part of the retainer ring shown in FIG. 4, and FIG. 10 is a view as viewed from line X-X of FIG. 9. As shown in FIGS. 9 and 10, substantially oblong grooves 418 extending vertically are formed in the outer circumferential surface of the upper ring member 408a of the ring member 408 of the retainer ring 3. A plurality of oblong grooves 418 are formed at equal intervals in the outer circumferential surface of the upper ring member 408a. Further, a plurality of driving pins 349 projecting radially inwardly are provided on the outer peripheral portion 410a of the retainer ring guide 410. The driving pins 349 are configured to be engaged with the oblong grooves 418 of the ring member 408, respectively. The ring member 408 and the driving pin 349 are slidable vertically relative to each other in the oblong groove 418, and the rotation of the top ring body 2 is transmitted through the upper member 300 and the retainer ring guide 410 to the retainer ring 3 by the driving pins 349 to rotate the top ring body 2 and the retainer ring 3 integrally. A rubber cushion 350 is provided on the outer circumferential surface of the driving pin 349, and a collar 351 made of a low friction material such as PTFE or PEEK·PPS is provided on the rubber cushion 350. Further, mirror processing is applied to the inner surface of the oblong groove 418 to improve surface roughness of the inner surface of the oblong groove 418 with which the collar 351 made of a low friction material is bought into sliding contact.

In this manner, the collar 351 made of the low friction material is provided on the driving pin 349, and mirror processing is applied to the inner surface of the oblong groove 418 with which the collar 351 is brought into sliding contact, thus enhancing the sliding characteristics between the driving pin 349 and the ring member 408. Therefore, the following capability of the ring member 408 with respect to the polishing surface can be remarkably enhanced, and a desired surface pressure of the retainer ring can be applied to the polishing surface. Mirror processing may be applied to the driving pin 349 and a low friction material may be provided on the oblong groove 418 of the ring member 408 with which the driving pin 349 is engaged.

As shown in FIGS. 2 through 9, a connection sheet 420, which can be expanded and contracted in a vertical direction, is provided between an outer circumferential surface of the ring member 408 and a lower end of the retainer ring guide 410. The connection sheet 420 is disposed so as to fill a gap between the ring member 408 and the retainer ring guide 410. Thus, the connection.sheet 420 serves to prevent a polishing liquid (slurry) from being introduced into the gap between the ring member 408 and the retainer ring guide 410. A band 421 comprising a belt-like flexible member is provided between an outer circumferential surface of the cylinder 400 and an outer circumferential surface of the retainer ring guide 410. The band 421 is disposed so as to cover a gap between the cylinder 400 and the retainer ring guide 410. Thus, the band 421 serves to prevent a polishing liquid (slurry) from being introduced into the gap between the cylinder 400 and the retainer ring guide 410.

The elastic membrane 314 includes a seal portion 422 connecting the elastic membrane 314 to the retainer ring 3 at an edge (periphery) 314d of the elastic membrane 314. The seal portion 422 has an upwardly curved shape. The seal portion 422 is disposed so as to fill a gap between the elastic membrane 314 and the ring member 408. The seal portion 422 is made of a deformable material. The seal portion 422 serves to prevent a polishing liquid from being introduced into the gap between the elastic membrane 314 and the ring member 408 while allowing the top ring body 2 and the retainer ring 3 to be moved relative to each other. In the present embodiment, the seal portion 422 is formed integrally with the edge 314d of the elastic membrane 314 and has a U-shaped cross-section.

If the connection sheet 420, the band 421 and the seal portion 422 are not provided, a polishing liquid may be introduced into an interior of'the top ring 1 so as to inhibit normal operation of the top ring body 2 and the retainer ring 3 of the top ring 1. The connection sheet 420, the band 421 and the seal portion 422 prevent a polishing liquid from being introduced into the interior of the top ring 1. Accordingly, it is possible to operate the top ring 1 normally. The elastic membrane 404, the connection sheet 420, and the seal portion 422 are made of a highly strong and durable rubber material such as ethylene propylene rubber (EPDM), polyurethane rubber, silicone rubber, or the like.

In the top ring 1, pressing forces to press a semiconductor wafer against a polishing surface are controlled by pressures of fluids to be supplied to the central chamber 360, the ripple chamber 361, the outer chamber 362, and the edge chamber 363 formed by the elastic membrane 314. Accordingly, the lower member 306 should be located away upward from the polishing pad 101 during polishing. However, if the retainer ring 3 is worn out, a distance between the semiconductor wafer and the lower member 306 is varied to change a deformation manner of the elastic membrane 314. Thus, surface pressure distribution is also varied on the semiconductor wafer. Such a variation of the surface pressure distribution causes unstable profiles of polished semiconductor wafers.

In the illustrated example, since the retainer ring 3 can vertically be moved independently of the lower member 306, a constant distance can be maintained between the semiconductor wafer and the lower member 306 even if the ring member 408 of the retainer ring 3 is worn out. Accordingly, profiles of polished semiconductor wafers can be stabilized.

In the illustrated example, the elastic membrane 314 is disposed so as to be brought into contact with substantially the entire surface of the semiconductor wafer. However, the elastic membrane 314 may be brought into contact with at least a portion of a semiconductor wafer.

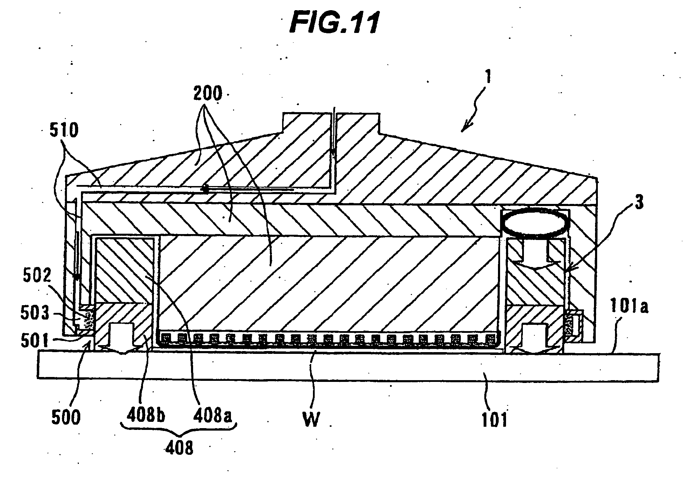

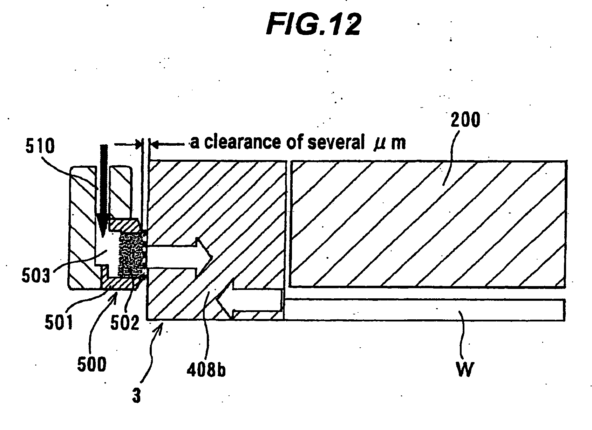

Next, a top ring according to another example will be described with reference to FIGS. 11 and 12.

FIG. 11 is a schematic cross-sectional view showing a top ring according to another example, and FIG. 12 is an enlarged view of a main part of FIG. 11. As shown in FIG. 11, in the top ring 1 according to this embodiment, the ring member 408 of the retainer ring 3 comprises an upper ring member 408a and a lower ring member 408b, and is supported by a fluid bearing 500 called an air bearing or the like. Specifically, the fluid bearing 500 fixed to a top ring body 200 is provided at an outer peripheral side of the ring member 408 of the retainer ring 3. The fluid bearing 500 comprises an annular housing 501 fixed to the top ring body 200, and a ring-shaped porous member 502 mounted in the housing 501. The porous member 502 is fixed to the housing 501 by adhesion, sintering or the like.

A passage 503 for supplying a pressurized fluid is formed in the housing 501, and the passage 503 is connected to a fluid supply source (not shown) through a passage 510 formed in the top ring body 200. Therefore, a pressurized fluid such as air or nitrogen gas is supplied to the porous member 502 through the passage 510 and the passage 503. The porous member 502 comprises metal such as copper, ceramics, or plastics, and has a number of voids (pores) formed therein. Thus, the pressurized fluid is supplied from the outer peripheral side to the inner peripheral side of the porous member 502 through these voids (pores). Therefore, a fluid film, such as an air film or a nitrogen gas film, having high load capability is formed between the ring member 408 and the porous member 502, and a lateral force applied to the ring member 408 is supported by the fluid film.

Specifically the lateral force is applied to the ring member 408 of the retainer ring 3 by a frictional force between the semiconductor wafer and the polishing surface, but the lateral force is supported by the fluid film. Thus, a clearance of several µm can be maintained between the porous member 502 and the ring member 408. Therefore, the ring member 408 is vertically movable with no-sliding (noncontact) against the porous member 502, and hence the following capability of the ring member 408 with respect to the polishing surface can be remarkably enhanced. The porous member 502 is impregnated with solid lubricant such as Teflon (registered trademark), and even if the ring member 408 is brought into contact with the porous member 502 by any chance, the ring member 408 maintains excellent sliding characteristics.

Further, a temperature control device such as a cooler may be provided in the passage connecting the passage 510 and the fluid supply source to cool a pressurized fluid supplied from the fluid supply source. The temperature of-the ring member 408 increases by'friction heat between the ring member 408 and the polishing surface.. However, the cooled pressurized fluid is blown on the outer circumferential surface of the ringmember 408 from the porous member 502, thus cooling the ring member 408. Therefore, the temperature of the ring member 408 can be prevented from rising to suppress thermal expansion of the ring member 408. Thus, a clearance between the porous member 502 and the ring member 408 can be minimized, and the pressure of the fluid film formed between the porous member 502 and the ring member 408 can be increased to enhance the effect of the air bearing. Therefore, the ring member 408 is vertically movable with no-sliding (noncontact) against the porous member 502, and hence the following capability of the ring member 408 with respect to the polishing surface can be further enhanced.

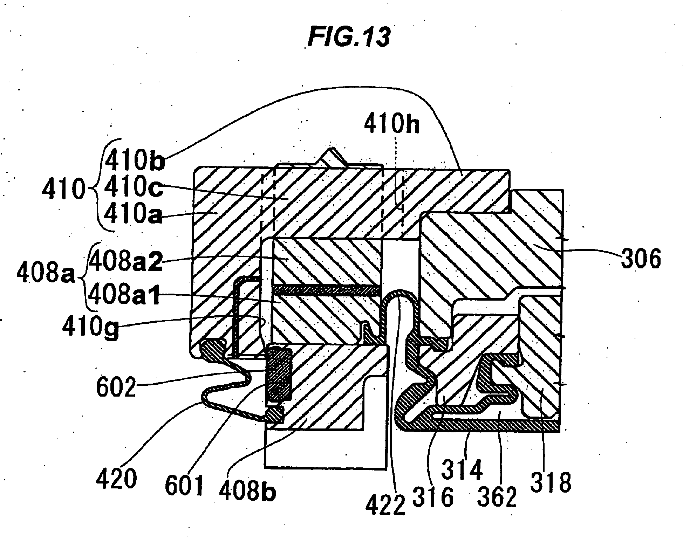

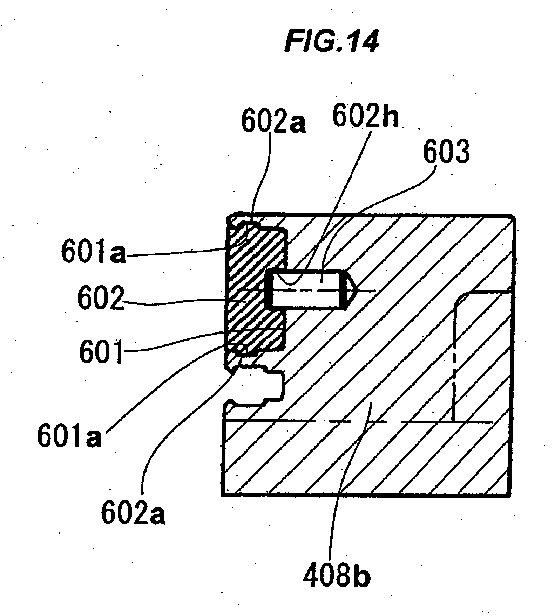

Next, a retainer ring according to an embodiment of the present invention will be described with reference to FIGS. 13 and 14. FIG. 13 is a cross-sectional view showing a retainer ring according to still another embodiment of the present invention. FIG.13 is a view corresponding to FIG. 8. In the example shown in FIG. 8, the thin metal ring 430 made of SUS or the like is fitted over the lower ring member 408b of the retainer ring 3, and the metal ring 430 is coated with a low friction material such as PTFE or PEEK·PPS.

In the embodiment shown in FIG. 13, a member comprising a low friction material is directly provided on the outer circumference of the lower ring member 408b of the retainer ring 3. Specifically, as shown in FIG. 13, a groove 601 having a substantially rectangular cross section is formed over an entire outer circumference of the lower ring member 408b of the retainer ring 3. A low friction material member 602 having a substantially rectangular cross section is fitted in the groove 601. The low friction material member 602 is made of a resin material such as polytetrafluoroethylene (PTFE) or PEEK· PPS. The resin material such as PTFE or PEEK·PPS is a low friction material having a low coefficient of friction, and has excellent sliding characteristics. The low friction material is defined as a material having a low coefficient of friction of 0.35 or less. It is desirable that the low friction material has a coefficient of friction of 0.25 or less.

FIG. 14 is an enlarged view of a main part of FIG. 13 showing a fitting portion of the groove 601 of the lower ring member 408b and the low friction material member 602. FIG. 14 shows the state in which the connection sheet 420 is removed from the lower ring member 408b. As shown in FIG. 14, a recess 601a hollowed upwardly is formed in an upper inner surface of the groove 601 having a rectangular cross section of the lower ringmember 408b, and a recess 601a hollowed downwardly is formed in a lower inner surface of the groove 601 having a rectangular cross section of the lower ring member 408b. A projection 602a bulged upwardly is formed in an upper outer surface of the low friction material member 602, and a projection 602a bulged downwardly is formed in a lower outer surface of the low friction material member 602. The upper and lower projections 602a, 602a of the low friction material member 602 are fitted in the upper and lower recesses 601a, 601a of the lower ring member 408b with no-clearance, respectively. Thus, the low friction material member 602 is prevented from dropping out of the lower ring member 408b. That is, the upper and lower projections 602a, 602a of the low friction material member 602 and the upper and lower recesses 601a, 601a of the lower ring member 408b constitute a retaining means for preventing the low friction material member 602 from dropping out of the lower ring member 408b. This retaining means may be composed of a recess formed in the low friction material member 602 and a projection formed on the lower ring member 408b. When the low friction material member 602 is mounted in the groove 601 of the lower ring member 408b, the projections 602a, 602a are deformable because the low friction material member 602 is made of a resin material, and hence the projections 602a, 602a are first deformed and then fitted into the recesses 601a, 601a, respectively. The projections 602a, 602a may be mountain-shaped in whole and have a tapered surface at both ends, or may be circular arc in whole and have a curved surface at both ends.

Further, as shown in FIG. 14, a pin 603 is fixed into the bottom surface of the groove 601 of the lower ring member 408b, and a hole 602h is formed in the inner surface of the low friction material member 602. The forward end portion of the pin 603 is fitted into the hole 602h of the low friction material member 602. Thus, the low friction material member 602 is prevented from being rotated in a circumferential direction of the lower ring member 408b. Specifically, the pin 603 fixed into the groove 601 of the lower ring member 408b, and the hole 602h formed in the low friction material member 602 constitute a rotation-prevention means for preventing the low friction material member 602 from being rotated with respect to the lower ring member 408b. This rotation-prevention means may be composed of a projection formed in one of the grove 601 of the lower ring member 408b and the inner surface of the low friction material member 602 and a recess formed in the other of the groove 601 of the lower ring member 408b and the inner surface of the low friction material member 602.

The low friction material member 602 is composed of not a ring member but a belt-like member which is formed into a circular arc. Since the low friction material member 602 has flexibility, the low friction material member 602 may be first formed into a linear shape and then fitted into the groove 601 of the lower ring member 408b of the retainer ring 3 to become a circular arc corresponding to the circular arc of the retainer ring 3.

The low friction material member 602 has a substantially rectangular cross section. The projection 602a bulged upwardly is formed on the upper outer surface of the low friction material member 602, and the projection 602a bulged downwardly is formed on the lower outer surface of the low friction material member 602. As described above, the projections 602a, 602a are configured to be fitted into the recesses 601a, 601a of the lower ring member 408b, respectively. Further, the hole 602h is formed in the central portion of the low friction material member 602. As described above, the hole 602h is arranged such that the pin 603 fixed into the groove 601 of the lower ring member 408b is fitted into the hole 602h. A plurality of holes 602h to be fitted by the pins 603 may be formed.

The rotation-prevention means may be composed of a combination of a key and a key groove in place of the hole.

The low friction material member 602 is composed of not a ring member but divided belt-like members, and these belt-like members may be fitted into the groove 601 of the lower ring member 408b of the retainer ring 3. For example, eight belt-like members whose both ends have a central angle (θ) of about 45° are fitted into the groove 601 of the lower ring member 408b of the retainer ring 3, and the entire circumference of the lower ring member 408b of the retainer ring 3 is covered with the low friction material member 602 comprising the eight belt-like members. When these eight belt-like members are fitted into the groove 601 of the lower ring member 408b, a small clearance is formed between the adjacent two belt-like members. This clearance is arranged to prevent the ends of the adjacent two belt-like members from coming into contact with each other, even if the belt-like members are thermally expanded due to temperature rise of the retainer ring 3 as polishing process progresses. The clearance is preferably in the range of about 0.1mm to about 1mm in view of thermal expansion coefficient of the low friction material member 602.

In the case where the low friction material member 602 is composed of a ring member, thermal expansion is repeated to form a radial clearance between the low friction material member 602 and the lower ring member 408b, and the low friction material member 602 becomes unfixed. However, since the' low friction material member 602 is composed of not a ring member but the divided belt-like members, and a clearance is formed between the adjacent two belt-like members, a radial clearance is not formed between the low friction material member 602 and the lower ring member 408b.

The belt-like member is arranged such that both ends of the belt-like member have a central angle (θ) of about 45°.. The central angle (θ) of the belt-like member may be larger than 45° or smaller than 45° . If the central angle (θ) of the belt-like member is large, the number of the belt-like members are reduced. If the central angle (θ) of the belt-like member is small, the number of the belt-like members are increased. The entire circumference of the lower ring member 408b of the retainer ring 3 can be covered with the low friction material member 602 by adjusting the number of the belt-like members. If the central angle (θ) of the member is small, such member is in the form of not belt but rectangular parallelepiped or block. The number of division of the low friction material member 602 (the number of segments) should be two or more, and it is desirable that the low friction material member 602 should be divided into equal segments.

On the other hand, the inner circumferential surface of the outer peripheral portion 410a of the retainer ring guide 410 constitutes a guide surface 410g which is brought into sliding contact with the low friction material member 602. The guide surface 410g has an improved surface roughness by mirror processing. The mirror processing is defined as a processing including polishing, lapping, and buffing.

As described above, the low friction material member 602 is fitted over an entire or substantially entire outer circumference of the lower ring member 408b of the retainer ring 3. The guide surface 410g of the retainer ring guide 410 has an improved surface roughness by mirror processing, and hence the sliding characteristics between the lower ring member 408b of the retainer ring 3 and the retainer ring guide 410 can be improved. Accordingly, the following capability of the ring member 408 with respect to the polishing surface can be, remarkably enhanced, and a desired surface pressure of the-retainer ring can be applied to the polishing surface.

Although certain preferred embodiments of the present invention have been shown and described in detail, it should be understood that various changes and modifications may be made therein within the scope of the appended claims.

## Claims

1. An apparatus for polishing a substrate (W), comprising:
a polishing table (100) having a polishing surface (101a);
a top ring body (2, 200) configured to hold and press a substrate (W) against said polishing surface (101a);
a retainer ring (3) provided at an outer peripheral portion of said top ring body (2, 200) and configured to press said polishing surface (101a); and
a retainer ring guide (410) fixed to said top ring body (2, 200) and configured to be brought into sliding contact with a ring member (408, 408b) of said retainer ring (3) to guide a movement of said ring member (408, 408b), **characterized in that**:
a low friction material member (602), having a coefficient of friction of 0.35 or less, is fitted onto an outer circumference of said ring member (408, 408b) of said retainer ring (3) to bring said low friction material member into sliding contact with said retainer ring guide (410), wherein said low friction material member (602) comprises a belt-like or block-like member having both ends, wherein a plurality of said belt-like or block-like members are provided on an outer circumference of said ring member (408b) in such a manner that a clearance is formed between the adjacent belt-like or block-like members.

2. The apparatus according to claim 1, wherein said low friction material member (602) comprises a resin material comprising polytetrafluoroethylene (PTFE) or PEEK·PPS.

3. The apparatus according to claim 2, wherein said low friction material member (602) comprises a flexible member.

4. The apparatus according to claim 2 or 3, wherein said low friction material member (602) is mounted on said ring member (408b) to become a circular shape corresponding to an outer circumference of said ring member (408b).

5. The apparatus according to any one of claims 1 to 4, further comprising a retaining device provided at a location where said low friction material member (602) is fitted onto said ring member (408b) and configured to prevent said low friction material member (602) from dropping out of said ring member (408b).

6. The apparatus according to any one of claims 1 to 5, wherein a rotation-prevention device configured to prevent said low friction material member (602) from being rotated with respect to said ring member (408b) is provided.

## Patentansprüche

1. Eine Vorrichtung zum Polieren eines Substrats (W), die Folgendes aufweist:
einen Poliertisch (100) mit einer Polieroberfläche (101 a);
einen Topringkörper (2, 200), der konfiguriert ist zum Halten und Drücken eines Substrats (W) gegen die Polieroberfläche (101a);
einen Haltering (3), der an einem Außenumfangsteil des Topringkörpers (2, 200) vorgesehen ist, und der konfiguriert ist zum Drücken gegen die Polieroberfläche (101 a); und
eine Halteringführung (410), die an dem Topringkörper (2, 200) befestigt ist, und die konfiguriert ist um in Gleitkontakt mit einem Ringglied (408, 408b) des Halterings (3) gebracht zu werden, um eine Bewegung des Ringgliedes (408, 408b) zu führen, **dadurch gekennzeichnet, dass**:
ein Glied (602) aus einem Material mit geringer Reibung, mit einem Reibungskoeffizienten von 0,35 oder kleiner auf einen Außenumfang des Ringgliedes (408, 408b) des Halterings (3) aufgebracht bzw. aufgepasst ist, um das Glied aus Material mit geringem Reibungskoeffizienten in Gleitkontakt mit der Halteringführung (410) zu bringen, wobei das Glied (602) aus Material mit geringem Reibungskoeffizienten ein bandförmiges oder blockförmiges Glied mit zwei Enden aufweist, wobei eine Vielzahl der bandförmigen oder blockförmigen Glieder an einem Außenumfang des Ringgliedes (408b) vorgesehen ist, und zwar in einer solchen Art und Weise, dass ein Freiraum zwischen den benachbarten bandförmigen oder blockförmigen Gliedern gebildet wird.

2. Vorrichtung nach Anspruch 1, wobei das Glied aus Material mit geringem Reibungskoeffizienten ein Harzmaterial aufweist, das Polytetrafluorethylen (PTFE) oder PEEK x PPS aufweist.

3. Vorrichtung nach Anspruch 2, wobei das Glied (602) aus Material mit geringem Reibungskoeffizienten ein flexibles Glied aufweist.

4. Vorrichtung nach Anspruch 2 oder 3, wobei das Glied (602) aus Material mit geringem Reibungskoeffizienten an dem Ringglied (408b) derart angebracht ist, dass es eine kreisförmige Form erhält, und zwar entsprechend zu einem Außenumfang des Ringgliedes (408b).

5. Vorrichtung nach einem der Ansprüche 1 bis 4, die ferner eine Haltevorrichtung aufweist, die an einem Ort vorgesehen ist, an dem das Glied (602) aus Material mit geringem Reibungskoeffizienten an das Ringglied (408b) angebracht ist, und das konfiguriert ist um zu verhindern, dass das Glied (602) aus Material mit geringem Reibungskoeffizienten aus dem Ringglied (408b) herausfällt.

6. Vorrichtung nach einem der Ansprüche 1 bis 5, wobei eine Drehverhinderungsvorrichtung vorgesehen ist, die konfiguriert ist zum Verhindern, dass sich das Glied (602) aus Material mit geringem Reibungskoeffizienten gegenüber dem Ringglied (408b) dreht.

## Revendications

1. Appareil pour polir un substrat (W), comprenant :
une table de polissage (100) comportant une surface de polissage (101a) ;
un corps annulaire supérieur (2, 200) agencé pour maintenir et presser un substrat (W) contre la surface de polissage (101a) ;
une bague de maintien (3) prévue au niveau d'une portion périphérique extérieure du corps annulaire supérieur (2, 200) et agencée pour presser la surface de polissage (101a) ; et
un guide de bague de maintien (410) fixé au corps annulaire supérieur (2, 200) et agencé pour être amené en contact coulissant avec un élément annulaire (408, 408b) de la bague de maintien (3) pour guider le mouvement de l'élément annulaire (408, 408b), **caractérisé en ce que** :
un élément en un matériau à faible frottement (602), ayant un faible coefficient de frottement inférieur ou égal à 0,35 est monté sur une périphérie extérieure de l'élément annulaire (408, 408b) de la bague de maintien (3) pour amener l'élément en un matériau à faible frottement en contact coulissant avec le guide de bague de maintien (410), l'élément en un matériau à faible frottement (602) comprenant un élément en forme de ceinture ou un élément en forme de bloc ayant deux extrémités, une pluralité d'éléments en forme de ceinture ou en forme de bloc étant prévue sur une périphérie extérieure de l'élément annulaire (408b) de façon à ce qu'un jeu soit formé entre les éléments en forme de ceinture ou en forme de bloc.

2. Appareil selon la revendication 1, dans lequel l'élément en un matériau à faible frottement (602) comprend une résine comprenant du polytétrafluoroéthylène (PTFE) ou du PEEK.PPS.

3. Appareil selon la revendication 2, dans lequel l'élément en un matériau à faible frottement (602) comprend un élément souple.

4. Appareil selon les revendications 2 ou 3, dans lequel l'élément en un matériau à faible frottement (602) est monté sur l'élément annulaire (408b) pour prendre une forme circulaire correspondant à une périphérie extérieure de l'élément annulaire (408b).

5. Appareil selon l'une quelconque des revendications 1 à 4, comprenant en outre un dispositif de maintien prévu au niveau d'un emplacement où l'élément en un matériau à faible frottement (602) est monté sur l'élément annulaire (408b) et agencé pour empêcher l'élément en un matériau à faible frottement (602) de se décrocher de l'élément annulaire (408b).

6. Appareil selon l'une quelconque des revendications 1 à 5, dans lequel il est prévu un dispositif d'empêchement de rotation agencé pour empêcher l'élément en un matériau à faible frottement (602) de tourner par rapport à l'élément annulaire (408b).
